# EUROPEAN PATENT APPLICATION

(11) **EP 4 726 491 A1**
(43) Date of publication of application: **15.04.2026**
(21) Application number: 24205852.7
(22) Date of filing: 10.10.2024
(51) Int. Cl.: G05D 16/20

(54) **VALVE AND CHAMBER MATCHING**

(71) Applicant: VAT Holding AG, 9469 Haag (CH)
(72) Inventor: REYERO SANTIAGO, Pedro, 9470 Buchs (CH); ERNST, Preston, 9435 Heerbrugg (CH); MAYRHOFER, Dominic, 9000 St. Gallen (CH)
(74) Representative: Kaminski Harmann

(57) **Abstract**

Method for providing secondary controlling parameters for controlling a secondary vacuum valve (10'), the method comprises generating primary controlling parameters for controlling a primary vacuum valve (10) by providing a target processing information, providing a first process chamber (1) comprising the primary vacuum valve (10) to control a fluid flow into or out of the first process chamber (1), running a reference processing cycle with variation of valve positions of a valve closure of the primary vacuum valve (10) as a function of the target processing information with deriving a first processing information related to the first process chamber (1), and adjusting the valve positions based on comparing the first processing information with the target processing information, and deriving the primary controlling parameters for the primary vacuum valve (10) based at least on the derived first processing information and the related valve positions, providing a second process chamber (1') comprising the secondary vacuum valve (10') to control a fluid flow into or out of the second process chamber (1'), and controlling the secondary vacuum valve (10') based on the primary controlling parameters, wherein the primary controlling parameters are provided as secondary controlling parameters.

## Description

### FIELD OF INVENTION

The invention relates to a method and controller which provide adjusted pressure control for a process cycle of a vacuum application performed with several valves or processing chambers.

### BACKGROUND OF THE INVENTION

In general, vacuum valves for regulating a volume or mass flow and for substantially gas-tight closure of a flow path, which leads through an opening formed in a valve housing are known in various embodiments from the prior art and are used in particular in vacuum chamber systems in the area of IC, semiconductor or substrate fabrication which must take place in a protected atmosphere as far as possible without the presence of contaminating particles.

Such vacuum chamber systems comprise in particular at least one evacuatable vacuum chamber for receiving semiconductor elements or substrates to be processed or fabricated, which has at least one vacuum chamber opening, through which the semiconductor elements or other substrates can be guided into and out of the vacuum chamber as well as at least one vacuum pump for evacuating the vacuum chamber. For example, in a production plant for semiconductor wafers or liquid crystal substrates, highly sensitive semiconductor or liquid crystal elements run sequentially through a plurality of process vacuum chambers in which the parts located inside the process vacuum chambers are processed by means of a processing device in each case. Both during the processing process inside the process vacuum chambers and also during transport from chamber to chamber the highly sensitive semiconductor elements or substrates must always be located in a protected atmosphere - in particular in an air-free environment.

On the one hand, peripheral valves for opening and closing a gas supply or discharge and, on the other hand, transfer valves for opening and closing the transfer openings of the vacuum chambers are used for the purpose of introducing and removing the parts.

The type of vacuum valves through which semiconductor parts are passed are designated as vacuum transfer valves.

Peripheral valves are used, in particular, for controlling or regulating the gas flow between a vacuum chamber and a vacuum pump or another vacuum chamber.

Peripheral valves are located for example inside a pipe system between a process vacuum chamber or a transfer chamber and a vacuum pump, the atmosphere or another process vacuum chamber. The opening cross-section of such valves, also known as pump valves, is usually smaller than in the case of a vacuum transfer valve. Since peripheral valves are used depending on the area of application not only for complete opening and closing of an opening but also for controlling or regulating a flow through continuous adjustment of the opening cross-section between a complete open position and a gas-tight closed position, they are also designated as regulating valves. A possible peripheral valve for controlling or regulating the gas flow is the pendulum valve.

In a typical pendulum valve such as is known for example from US 6,089,537 (Olmsted), in a first step a usually round valve disk is pivoted rotatably over an opening which is also usually round from a position which exposes the opening into an intermediate position which covers the opening. In the case of a slide valve such as is described in US 6,416,037 (Geiser) or US 6,056,266 (Blecha), the valve disk and also the opening is usually configured to be rectangular and in this first step is pushed linearly from a position which exposes the opening into an intermediate position which covers the opening. In this intermediate position, the valve disk of the pendulum valve or slide valve is located in a spaced-apart opposite position to the valve seat surrounding the opening. In a second step, the distance between the valve disk and the valve seat is reduced so that the valve disk and the valve seat are pressed uniformly onto one another and the opening is closed in a substantially gastight manner. This second movement preferably takes place substantially in a perpendicular position to the valve seat.

The sealing can be accomplished, for example, either via a sealing ring arranged on the closure side of the valve disk which is pressed onto the valve seating which runs around the opening or via a sealing ring on the valve seat against which the closure side of the valve disk is pressed. As a result of the closure process which takes place in two steps, the sealing ring is barely subjected to shear forces which would destroy the sealing ring between the valve disk and the valve seat since the movement of the valve disk in the second step takes place substantially rectilinearly perpendicularly onto the valve seat.

Various sealing devices are known from the prior art, for example, from US 6,629,682 B2 (Duelli). A suitable material for sealing rings and seals in vacuum valves is, for example, fluororubber, also known as FKM, in particular, the fluoroelastomer known under the trade name "Viton" as well as perfluororubber, FFKM for short.

Since the aforementioned valves find application, inter alia, in the production of highly sensitive semiconductor elements, the generation of particles - caused, in particular, by the actuation of the valve and by the mechanical loading of the valve-shutter member - and the number of free particles in the valve chamber have to be kept as low as possible. The generation of particles is primarily a consequence of friction, for instance as a result of metal/metal contact and as a result of abrasion.

As described above, vacuum regulating valves are used for adjusting a defined process environment in a process chamber. The regulation is typically accomplished here by means of a pressure signal which provides information relating to the chamber internal pressure and by means of a target value, i.e. a desired pressure which should be achieved by means of the regulation. The position of a valve closure (valve disk) is then varied in the course of the regulation, e.g. a closed-loop regulation, so that the desired pressure is achieved within a certain time interval.

In contrast to regulation, vacuum regulating valves can also be operated in a controlled manner by means of known process parameters such as, for example, a desired pressure to be achieved in the process chamber in a predefined time. For this purpose, for example relevant desired positions for the valve disk are provided and this position is approached in likewise predefined times.

Both the above methods have their specific advantages and disadvantages. Thus, a desired pressure in the process chamber can be set in a relatively short time by means of a predefined control but as a result of a typically lacking feedback (e.g. current pressure information), a prediction on the currently prevailing pressure can only be made with reservations. Any undesired influences on the production process such as, for example a changed gas inlet or a leak of the process chamber remain completely unidentified and then typically result in a reduction in the fabrication quality.

In fields of applications of vacuum processing an operator intends to have a plurality of process chambers to provide particular (high) production capacity. Hence, workpieces or substrates can be produced in parallel to provide increased output. Of course, all the workpieces or substrates produced should have at least almost identical product characteristics and properties. Here, the desired pressures in the process chambers are typically set and varied by means of predefined controlling parameters used for the chambers.

One problem for such parallel processing is the fact that the process chambers and the peripheral devices, such as gas inlet valves or plasma sources, can typically differ at least minimally from chamber to chamber. As a consequence, the process conditions inside different chambers may vary accordingly. Such deviation leads to products of different characteristics, e.g. different surface conditions.

### OBJECT OF THE INVENTION

It is therefore the object of the invention to provide an improved method or controller which overcomes possible deviations between parallel processing.

In particular, it is an object of the invention to provide an improved method or controller for controlling a set of vacuum valves to provide identical processing performances.

In particular, it is an object of the invention to provide an improved method which enables to adjust a processing performance of one process relative to a processing performance of another process.

These objects are solved by implementing the characterizing features of the independent claims. Features which further develop the invention in alternative or advantageous manner can be deduced from the dependent patent claims.

### SUMMARY OF THE INVENTION

The invention relates to an approach for controlling fluid flow in a process chamber by means of a vacuum valve. The approach is directed to provide such control for at least two different valves, wherein the controlling parameters for the respective valves are provided and aligned relative to each other such that processes of respectively connected process chambers can be performed with identical process conditions to achieve identical process results in different chambers.

The invention relates to a method for providing secondary controlling parameters for controlling a secondary vacuum valve. The method comprises generating primary controlling parameters for controlling a primary vacuum valve.

The primary controlling parameters are generated by providing a target processing information, e.g. target pressure profile, target pressure, target settling time etc., and providing a first process chamber comprising the primary vacuum valve to control fluid flow into and/or out of the first process chamber, in particular to control a downstream gas outlet flow out of the first process chamber.

Further, a reference processing cycle is run with variation of valve positions of a valve closure of the primary vacuum valve as a function of the target processing information with deriving a first processing information related to the first process chamber, and adjusting the valve positions based on comparing the first processing information with the target processing information.

A variation of a valve position of a valve closure can for example be provided at least based on defined controlling parameters for controlling or setting a position of the valve closure.

The valve position is a position of the valve closure relative to the valve seat, i.e. an actual flow rate can be varied and set by changing or setting the valve position. Hence, an opening cross section depends on the valve position.

The primary controlling parameters for the primary vacuum valve are derived based at least on the derived first processing information and the related valve positions.

A second process chamber is provided which comprises the secondary vacuum valve to control a fluid flow into and/or out of the second process chamber, in particular to control a downstream gas outlet flow out of the second process chamber.

The secondary vacuum valve is controlled based on the primary controlling parameters, wherein the primary controlling parameters are provided as secondary controlling parameters.

Hence, the method enables to control a secondary vacuum valve according to a primary vacuum valve, i.e. by applying identical controlling parameters.

In one embodiment, the second process chamber can be provided by the first process chamber, in particular wherein the first and the second process chamber are identical. In other words, the primary and the secondary vacuum valve are provided with one and the same process chamber. This becomes important, for instance, in case a vacuum valve of a chamber is replaced or exchanged and the processing should be continued with the new valve in identical manner. The new valve can be run with the controlling parameters of the old, exchanged valve.

In one embodiment, generating the primary controlling parameters can be provided by simulating a change of the first processing information as a function of adjusting the valve positions based on a digital model, the digital model provides information about the first process chamber and the primary vacuum valve. By that, an ideal processing behavior and respective controlling parameters can be derived and be used as a basis for aligning the controlling of other, real valves.

According to one embodiment, the first processing information can comprise at least one of
- a valve position or valve position profile,
- a pressure in the process chamber or a pressure profile,
- settling time,
- a regulation time,
- a pressure overshoot or undershoot,
- a pressure error,
- a maximum pressure deviation, and
- a temperature, in particular an actual temperature in the process chamber.

The first processing information can thus be used as a basis to decide a (further) change of the valve position to change the fluid flow. As for example, the pressure in the process chamber depends on the temperature inside the chamber and a flow rate through the vacuum valve can be adjusted according to the temperature to compensate pressure deviation. Further, a change of the valve position may be performed as a function of the pressure deviation.

In one embodiment, the secondary controlling parameters for controlling the secondary vacuum valve can be adjusted by providing the target processing information, running an adjusting processing cycle with variation of valve positions of a valve closure of the secondary vacuum valve as a function of the target processing information with deriving a second processing information related to the second process chamber, adjusting the valve positions based on the primary controlling parameters and comparing the second processing information with the target processing information, and deriving adjusted secondary controlling parameters for the secondary vacuum valve based at least on the derived second processing information and the related valve positions.

Hence, the secondary controlling parameter can be adjusted according to the properties of the second process chamber to provide identical performance with the first process chamber. This step can further improve and guarantee identical performances.

The invention also relates to a method for aligning a processing performance of a first process chamber with a processing performance of a second process chamber.

This method comprises providing a target processing information, providing a first process chamber comprising a first vacuum valve to control fluid flow into and/or out of the first process chamber, in particular to control a downstream gas outlet flow out of the first process chamber, and providing a second process chamber comprising the second vacuum valve to control fluid flow into and/or out of the second process chamber, in particular to control a downstream gas outlet flow out of the second process chamber.

First controlling parameters for controlling the first vacuum valve are generated by running a first processing cycle with variation of valve positions of a valve closure of the first vacuum valve as a function of the target processing information by deriving a first processing information related to the first process chamber, adjusting the valve positions based on comparing the first processing information with the target processing information, and deriving the first controlling parameters for the first vacuum valve based at least on the derived first processing information and the related valve positions.

Second controlling parameters for controlling the second vacuum valve are generated by running a second processing cycle with variation of valve positions of a valve closure of the second vacuum valve as a function of the target processing information by deriving a second processing information related to the second process chamber, adjusting the valve positions based on comparing the second processing information with the target processing information, and deriving the second controlling parameters for the second vacuum valve based at least on the derived second processing information and the related valve positions.

The first and the second processing information is compared, and a commonly applicable processing information is derived based on the comparing of the first and the second processing information.

This method aims to provide identical performances of process chambers without assuming one of the chambers is the basis for relative performance alignment. A faster working process chamber may preferably be aligned to the performance or profile of a slower working chamber.

In one embodiment, the commonly applicable processing information can be compared with the first processing information and, based thereon, the first controlling parameters can be adjusted.

Such adjustment of the first controlling parameters can in particular comprise running an adjusting processing cycle with variation of a valve positions of a valve closure of the first vacuum valve as a function of the commonly applicable processing information by deriving an updated first processing information related to the first process chamber, and adjusting the valve positions based on the first controlling parameters and based on comparing the updated first processing information with the commonly applicable processing information. The first controlling parameters for the first vacuum valve are adjusted based at least on the derived updated first processing information and the related valve positions.

In one embodiment, the commonly applicable processing information can be compared with the second processing information and, based thereon, the second controlling parameters are adjusted.

In one embodiment, adjusting the second controlling parameters can comprise running an adjusting processing cycle with variation of a valve positions of a valve closure of the second vacuum valve as a function of the commonly applicable processing information by deriving an updated second processing information related to the second process chamber, adjusting the valve positions based on the second controlling parameters and based on comparing the updated second processing information with the commonly applicable processing information, and adjusting the second controlling parameters for the second vacuum valve based at least on the derived updated second processing information and the related valve positions.

In one embodiment, the first processing information, the second processing information and/or the target processing information can comprise at least one of a valve position or valve position profile, a pressure in the process chamber or a pressure profile, settling time, a regulation time, a pressure overshoot or undershoot, a pressure error, a maximum pressure deviation, and a temperature, in particular an actual temperature in the process chamber.

Further, at least one of the processing information can comprise a trajectory which is derived by comparing or processing a number of trajectories of serval valves. By processing several trajectories, a desired trajectory can be computed which represents a trajectory feasible to be run by each of the valves or by a valve to be matched to the other valves. As for example, the desired trajectory may basically correspond with a trajectory of one of the valves but may be slightly adjusted for compensating for an overshoot.

The invention also relates to a controller for controlling at least one vacuum valve to control the pressure in at least one process chamber by means of the vacuum valve, wherein the controller is configured to control the at least one vacuum valve based on respective controlling parameters assigned to the at least one vacuum valve.

In one embodiment, the at least one vacuum valve can be a secondary vacuum valve and the respective controlling parameters are secondary controlling parameters to control the secondary vacuum valve, and the controller is configured to derive the secondary controlling parameters by receiving primary controlling parameters for controlling a primary vacuum valve, and deriving the secondary controlling parameters for controlling the secondary vacuum valve. Deriving the secondary controlling parameters comprises providing a target processing information, and running an adjusting processing cycle with variation of valve positions of a valve closure of the secondary vacuum valve as a function of the target processing information by deriving a second processing information related to the second process chamber, adjusting the valve positions based on the primary controlling parameters and comparing the second processing information with the target processing information. Adjusted secondary controlling parameters for the secondary vacuum valve are derived based at least on the derived second processing information and the related valve positions.

In one embodiment, the at least one vacuum valve can be a first vacuum valve of a first process chamber and the respective controlling parameters are first controlling parameters to control the first vacuum valve, and the controller is configured to control a second vacuum valve of a second process chamber based on second controlling parameters, wherein the controller is configured to align a processing performance of the first process chamber with a processing performance of the second process chamber.

The aligning of the processing performance of the first process chamber with a processing performance of the second process chamber comprises providing a target processing information (e.g. pressure profile, settling time etc.), and generating first controlling parameters for controlling the first vacuum valve by running a first processing cycle with variation of valve positions of a valve closure of the first vacuum valve as a function of the target processing information by deriving a first processing information related to the first process chamber, adjusting the valve positions based on comparing the first processing information with the target processing information, and deriving the first controlling parameters for the first vacuum valve based at least of the derived first processing information and the related valve positions.

Further, second controlling parameters for controlling the second vacuum valve are generated by running a second processing cycle with variation of valve positions of a valve closure of the second vacuum valve as a function of the target processing information by deriving a second processing information related to the second process chamber, adjusting the valve positions based on comparing the second processing information with the target processing information, and deriving the second controlling parameters for the second vacuum valve based at least on the derived second processing information and the related valve positions.

The first and the second processing information are compared, and a commonly applicable processing information based on the comparing of the first and the second processing information is derived.

In one embodiment, the controller can be configured to compare the commonly applicable processing information with the first processing information and, based thereon, adjusting the first controlling parameters.

In one embodiment, adjusting the first controlling parameters can comprise running an adjusting processing cycle with variation of a valve positions of a valve closure of the first vacuum valve as a function of the commonly applicable processing information by deriving an updated first processing information related to the first process chamber, adjusting the valve positions based on the first controlling parameters and based on comparing the updated first processing information with the commonly applicable processing information, and adjusting the first controlling parameters for the first vacuum valve based at least on the derived updated first processing information and the related valve positions.

### BRIEF DESCRIPTION OF THE DRAWINGS

The apparatus according to the invention and the method according to the invention are described in detail hereinafter merely as an example with reference to specific exemplary embodiments shown schematically in the drawings, wherein further advantages of the invention are also discussed. In detail in the figures:
figure 1 schematically shows an embodiment of a process system for treatment or production of objects under vacuum conditions according to the invention;
figure 2 schematically shows an embodiment of a process system for treatment or production of objects under vacuum conditions according to the invention according to the invention;
figures 3a and 3b show pressure control profiles and matching of the profiles; and
figure 4 shows the steps of a method to provide controlling parameters to control a vacuum valve based on a desired profile.

### DETAILED DESCRIPTION OF THE DRAWINGS

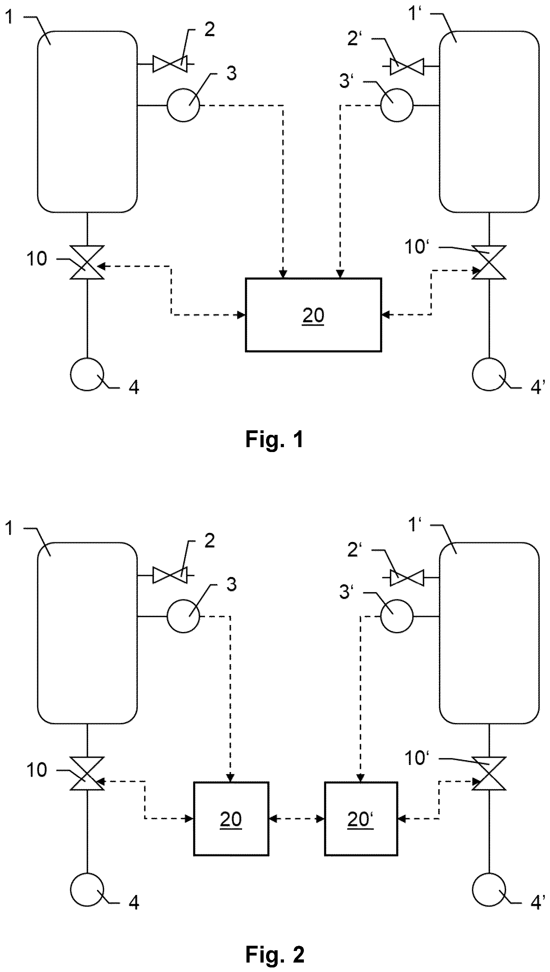

Figure 1 shows schematically an embodiment of a process system for treatment or production of objects under vacuum conditions. The system comprises two process chambers 1 and 1'. Each process chamber 1,1' is connected to a feed line for providing a fluid into the respective process chamber (upstream). Said feed lines being provided with peripheral devices 2 and 2', like gas-flow meters, mass flow controllers, inlet valves etc., with which a defined quantity of a particular fluid, e.g. process gas or precursor gas, that is flowing into the process chambers 1,1' can be measured or the inflowing quantity of fluid can be regulated appropriately. Furthermore, pressure sensors 3 and 3' are provided which permit a determination of the pressure in the interior of the respective process chamber 1,1' (chamber pressure).

On an outlet sides of the process chambers 1 and 1' vacuum pumps 4 and 4' are connected to the chambers 1,1' for evacuation thereof. Respective regulation vacuum valves 10 and 10' for controlling or regulating the outflowing mass flow of the respective chamber 1, 1' are arranged between the vacuum pumps 4, 4' and the chambers 1, 1' (downstream). The (controlled) setting of the valves 10, 10' can be realized, for example, by means of a motorized, pneumatic or hydraulic drive of the valve.

In accordance with the invention the system has a controller 20 (controlling unit) which is connected to the vacuum valves 10 and 10' and provides controlled variation of the respective valve positions, i.e. a position of the valve closure relative to the valve seat, by means of controlling signals.

Further, the controller 20 is connected to the pressure sensors 3, 3' for receiving and processing pressure signals of the sensors 3, 3'. Hence, the pressure sensors 3 and 3' are arranged to derive a (first and/or second) processing information related to the respective process chamber 1,1'.

In an alternative embodiment, the controller 20 can also be connected to the peripheral devices 2, 2' for controlling or measuring an amount of processing fluid provided into the process chambers 1, 1'.

The process chambers 1, 1' and the connected devices and components are intended to provide identical processing properties for the two chambers 1 and 1'. The processing properties are at least defined by a proper controlling of the vacuum valves 10 and 10'. By that, a defined or desired pressure profile inside the respective chamber 1, 1' for a processing cycle can be provided.

The vacuum valves 10 and 10' can preferably be controlled in an open-loop manner during processing of substrates or other workpieces. This means, in such case, there is no feedback information processed to provide closed-loop regulation of the chamber pressures.

Accordingly, in an alternative embodiment, at least one of the pressure sensors 3, 3' can be omitted, in particular after the controlling parameters are set and the process chamber is operated to process substrates or workpieces.

To provide identical processing properties, the pressure profiles of the two chambers 1, 1' can be aligned with each other. For that, according to the invention, specific (secondary) controlling parameters for controlling the (secondary) vacuum valve 10' are derived. Applying the secondary controlling parameter then provides a pressure profile in the second chamber 1' which is at least almost identical with the pressure profile in the first chamber 1 when applying primary controlling parameters to control the primary valve 10.

In a pre-step, the primary controlling parameters can be derived based on a learning or optimizing run with the first chamber 1 based on a known target pressure profile.

In one embodiment, these parameters may be derived by performing a model-based simulation.

The method of providing secondary controlling parameters for controlling the secondary vacuum valve 10' comprises generating primary controlling parameters for controlling a primary vacuum valve 10 by providing a target processing information. The target processing information can comprise a target pressure trajectory, a target pressure, a settling time, a desired processing time etc.

Next, a reference processing cycle is run by means of the first process chamber 1. The first process chamber 1 has the primary vacuum valve 10 to control a downstream gas outlet flow out of the first process chamber. Running the reference processing cycle comprises varying valve positions of a valve closure of the primary vacuum valve 10 as a function of the target processing information.

During the reference processing cycle a first processing information related to the first process chamber 1 is derived or measured, and the valve positions are adjusted based on comparing the first processing information with the target processing information. The first processing information can comprise an actual chamber pressure and/or a temperature in the chamber or of the fluid.

The primary controlling parameters for the primary vacuum valve 10 are derived based at least on the derived first processing information and the related valve positions. The combined knowledge of valve positions and first processing information, which is a result of the valve positions, provide a controlling of the primary valve 10 so that the target processing information can be provided.

The secondary vacuum valve 10' can then be controlled based on the primary controlling parameters, wherein the primary controlling parameters are provided as secondary controlling parameters, accordingly. In other words, the optimized controlling parameters for the primary valve 10 can be used to control the secondary valve 10'.

However, due to natural deviations from chamber to chamber, e.g. structural differences, differences in fluid conductance or the like, the secondary controlling parameters do typically have to be adjusted or optimized in a further step to provide identical processing.

Hence, the secondary controlling parameters for controlling the secondary vacuum valve 10' can be adjusted by providing the target processing information and running an adjusting processing cycle with variation of valve positions of a valve closure of the secondary vacuum valve 10' as a function of the target processing information.

By that, a second processing information related to the second process chamber is derived and the valve positions are adjusted based on the primary controlling parameters and based on comparing the second processing information with the target processing information. The adjusted secondary controlling parameters for the secondary vacuum 10' valve are derived based at least on the derived second processing information and the related secondary valve positions.

In other words, the controlling parameters for the secondary valve 10' and the secondary chamber 1' are generated on basis of the controlling parameters for the primary valve 10 and by adjusting the controlling parameters according to given conditions of the secondary process chamber 1'.

Figure 2 shows an embodiment of a process system for treatment or processing of substrates under vacuum conditions. The embodiment according to figure 2 differentiates from the embodiment according to figure 1 by the controlling units 20 and 20'.

According to figure 2, there is not a central controlling unit but each of the processing chambers and the respective devices are controlled by a separate controller 20, 20'. This means that the primary controlling parameters are derived on side of the first controlling unit 20 and are transferred to the second controlling unit 20' to be used or further processed to control the secondary vacuum valve 10'.

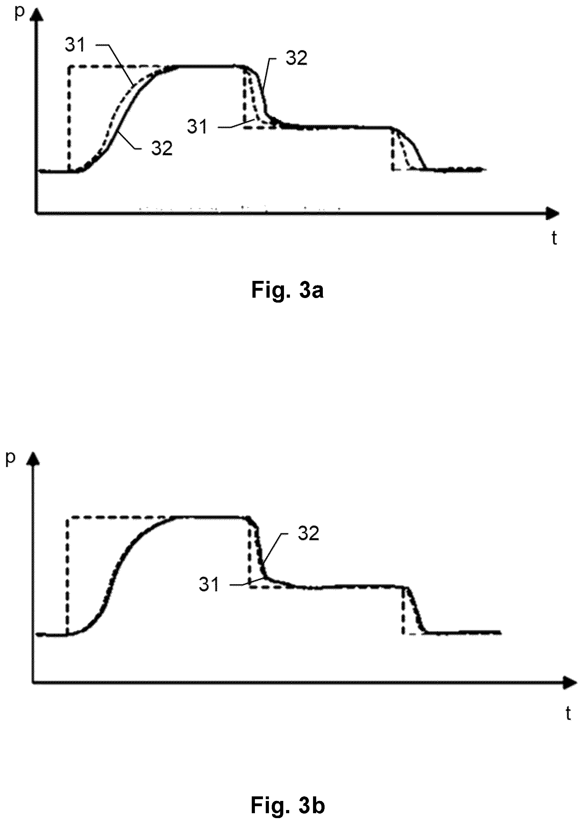

Figures 3a and 3b show the pressure profiles for two process chambers controlled by two vacuum valves.

Figure 3a shows a first pressure trajectory 31 which represents a desired pressure trajectory. Such profile 31 can be a respective controlling performance of a standard chamber, i.e. a chamber the performance of which should be transferred to other process chambers. Alternatively, such profile 31 can be derived based on a simulation of a desired processing cycle.

A second pressure trajectory 32 represents an initial chamber pressure control of a chamber the performance of which should be matched to the standard chamber.

As can be seen, there is significant deviation between the profiles 31 and 32. This deviation may typically result from different structural properties of the chambers and/or their peripheral devices even if the valve of the chamber to matched is driven with the controlling parameters for the standard chamber.

Figure 3b shows the process trajectory of the chamber to matched after adjusting the controlling parameters to drive the chamber. For that, an optimization routine (changing the controlling parameters) can be run to match as close as possible the desired pressure control behavior.

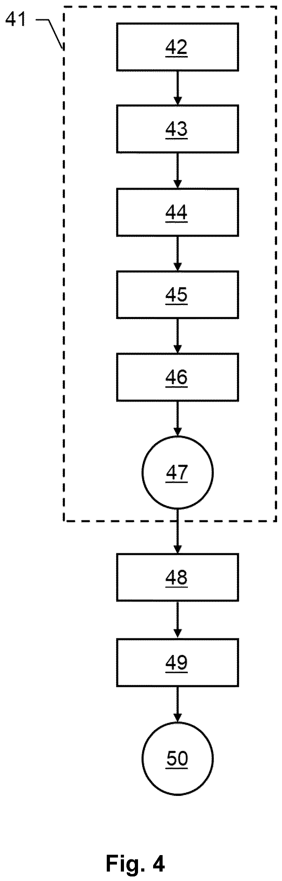

Figure 4 depicts a method for providing particular controlling parameters for controlling a (secondary) vacuum valve.

In a first sequence 41 primary controlling parameters for controlling a primary vacuum valve are generated. For that, a target processing information is provided 42, e.g. a target pressure profile, a target pressure, a settling time, a target valve position or valve position profile, a target regulation time, a maximal pressure deviation etc.

A first process chamber is provided 43 which comprises a primary vacuum valve to control fluid flow into and/or out of the first process chamber. The primary vacuum valve provided is considered to be the valve which other valves should be matched to.

A reference processing cycle is run 44 with variation of valve positions of a valve closure of the primary vacuum valve as a function of the target processing information. During running the reference processing cycle, a first processing information related to the first process chamber is derived 45, and the valve positions are adjusted 46 based on comparing the first processing information with the target processing information.

The primary controlling parameters for the primary vacuum valve are derived based at least on the derived first processing information and the related valve positions 47.

A second process chamber is provided 48 comprising a secondary vacuum valve to control fluid flow into and/or out of second process chamber.

The secondary vacuum valve is controlled based on the primary controlling parameters, wherein the primary controlling parameters are provided as secondary controlling parameters (step 49).

In a further, optional step 50, the secondary controlling parameters can be adjusted by running an adjusting processing cycle as described above

It is understood that the depicted figures only schematically depict possible exemplary embodiments. The various approaches can according to the invention also be combined with one another and with prior art methods and devices for pressure control for vacuum processes.

## Claims

1. Method for providing secondary controlling parameters for controlling a secondary vacuum valve (10'), the method comprises
• generating primary controlling parameters for controlling a primary vacuum valve (10) by
□ providing a target processing information,
□ providing a first process chamber (1) comprising the primary vacuum valve (10) to control a fluid flow into or out of the first process chamber (1),
□ running a reference processing cycle with variation of valve positions of a valve closure of the primary vacuum valve (10) as a function of the target processing information with
· deriving a first processing information related to the first process chamber (1), and
· adjusting the valve positions based on comparing the first processing information with the target processing information, and
□ deriving the primary controlling parameters for the primary vacuum valve (10) based at least on the derived first processing information and the related valve positions,
• providing a second process chamber (1') comprising the secondary vacuum valve (10') to control a fluid flow into or out of the second process chamber (1'), and
• controlling the secondary vacuum valve (10') based on the primary controlling parameters, wherein the primary controlling parameters are provided as secondary controlling parameters.

2. Method according to claim 1, wherein
the second process chamber (1') is provided by the first process chamber (1).

3. Method according to claim 1 or 2, wherein
generating the primary controlling parameters is provided by simulating a change of the first processing information as a function of adjusting the valve positions based on a digital model, the digital model provides information about the first process chamber (1) and the primary vacuum valve (10).

4. Method according to any of the preceding claims, wherein
the first processing information comprises at least one of
• a valve position or valve position profile,
• a pressure in the process chamber or a pressure profile,
• settling time,
• a regulation time,
• a pressure overshoot or undershoot,
• a pressure error,
• maximal pressure deviation, and
• temperature.

5. Method according to any of the preceding claims, wherein
the secondary controlling parameters for controlling the secondary vacuum valve (10') are adjusted by
• providing the target processing information,
• running an adjusting processing cycle with variation of valve positions of a valve closure of the secondary vacuum valve (10') as a function of the target processing information with
□ deriving a second processing information related to the second process chamber (1'),
□ adjusting the valve positions based on
· the primary controlling parameters and
· comparing the second processing information with the target processing information, and
• deriving adjusted secondary controlling parameters for the secondary vacuum valve (10') based at least on the derived second processing information and the related valve positions.

6. Method for aligning a processing performance of a first process chamber (1) with a processing performance of a second process chamber (2), the method comprises
• providing a target processing information,
• providing a first process chamber (1) comprising a first vacuum valve (10) to control a fluid flow into or out of the first process chamber (1),
• providing a second process chamber (1') comprising the second vacuum valve (10') to control a fluid flow into or out of the second process chamber (1'),
• generating first controlling parameters for controlling the first vacuum valve (10) by
□ running a first processing cycle with variation of valve positions of a valve closure of the first vacuum valve (10) as a function of the target processing information by
· deriving a first processing information related to the first process chamber (1),
· adjusting the valve positions based on comparing the first processing information with the target processing information, and
□ deriving the first controlling parameters for the first vacuum valve (10) based at least on the derived first processing information and the related valve positions,
• generating second controlling parameters for controlling the second vacuum valve (10') by
□ running a second processing cycle with variation of valve positions of a valve closure of the second vacuum valve (10') as a function of the target processing information by
· deriving a second processing information related to the second process chamber (1'),
· adjusting the valve positions based on comparing the second processing information with the target processing information, and
□ deriving the second controlling parameters for the second vacuum valve (10') based at least on the derived second processing information and the related valve positions,
• comparing the first and the second processing information, and
• deriving a commonly applicable processing information based on the comparing of the first and the second processing information.

7. Method according to claim 6, wherein
the commonly applicable processing information is compared with the first processing information and, based thereon, the first controlling parameters are adjusted.

8. Method according to claim 7, wherein
adjusting the first controlling parameters comprises
• running an adjusting processing cycle with variation of a valve positions of a valve closure of the first vacuum valve (10) as a function of the commonly applicable processing information by
□ deriving an updated first processing information related to the first process chamber (1),
□ adjusting the valve positions based on
· the first controlling parameters, and
· comparing the updated first processing information with the commonly applicable processing information, and
• adjusting the first controlling parameters for the first vacuum valve (10) based at least on the derived updated first processing information and the related valve positions.

9. Method according to any of the claims 6 to 8, wherein
the commonly applicable processing information is compared with the second processing information and, based thereon, the second controlling parameters are adjusted.

10. Method according to claim 9, wherein
adjusting the second controlling parameters comprises
• running an adjusting processing cycle with variation of a valve positions of a valve closure of the second vacuum valve (10') as a function of the commonly applicable processing information by
□ deriving an updated second processing information related to the second process chamber (1'),
□ adjusting the valve positions based on
· the second controlling parameters, and
· comparing the updated second processing information with the commonly applicable processing information, and
• adjusting the second controlling parameters for the second vacuum valve (10') based at least on the derived updated second processing information and the related valve positions.

11. Controller (20,20') for controlling at least one vacuum valve (10,10') to control the pressure in at least one process chamber (1,1') by means of the vacuum valve (10,10'), wherein the controller (20,20') is configured to control the at least one vacuum valve (10,10') based on respective controlling parameters assigned to the at least one vacuum valve (10,10').

12. Controller (20,20') according to claim 11, wherein
the at least one vacuum valve is a secondary vacuum valve (10') and the respective controlling parameters are secondary controlling parameters to control the secondary vacuum valve (10'), and the controller is configured to derive the secondary controlling parameters by
• receiving primary controlling parameters for controlling a primary vacuum valve (10),
• deriving the secondary controlling parameters for controlling the secondary vacuum valve (10') by
o providing a target processing information,
□ running an adjusting processing cycle with variation of valve positions of a valve closure of the secondary vacuum valve (10') as a function of the target processing information by
· deriving a second processing information related to the second process chamber (1'),
· adjusting the valve positions based on
(i) the primary controlling parameters and
(ii) comparing the second processing information with the target processing information, and
□ deriving adjusted secondary controlling parameters for the secondary vacuum valve (10') based at least on the derived second processing information and the related valve positions.

13. Controller (20,20') according to claim 11, wherein
the at least one vacuum valve is a first vacuum valve (10) of a first process chamber and the respective controlling parameters are first controlling parameters to control the first vacuum valve (10), and the controller (20,20') is configured to control a second vacuum valve (10') of a second process chamber (1') based on second controlling parameters, wherein the controller is configured to align a processing performance of the first process chamber (1) with a processing performance of the second process chamber (1') by
• providing a target processing information,
• generating first controlling parameters for controlling the first vacuum valve (10) by
□ running a first processing cycle with variation of valve positions of a valve closure of the first vacuum valve (10) as a function of the target processing information by
· deriving a first processing information related to the first process chamber (1),
· adjusting the valve positions based on comparing the first processing information with the target processing information, and
□ deriving the first controlling parameters for the first vacuum valve (10) based at least on the derived first processing information and the related valve positions,
• generating second controlling parameters for controlling the second vacuum valve (10') by
□ running a second processing cycle with variation of valve positions of a valve closure of the second vacuum valve (10') as a function of the target processing information by
· deriving a second processing information related to the second process chamber (1'),
· adjusting the valve positions based on comparing the second processing information with the target processing information, and
□ deriving the second controlling parameters for the second vacuum valve (10') based at least on the derived second processing information and the related valve positions,
• comparing the first and the second processing information, and
• deriving a commonly applicable processing information based on the comparing of the first and the second processing information.

14. Controller (20,20') according to claim 13, wherein
the controller (20,20') is configured to compare the commonly applicable processing information with the first processing information and, based thereon, adjusting the first controlling parameters.

15. Controller (20,20') according to claim 14, wherein
adjusting the first controlling parameters comprises
• running an adjusting processing cycle with variation of a valve positions of a valve closure of the first vacuum valve (10) as a function of the commonly applicable processing information by
□ deriving an updated first processing information related to the first process chamber (1),
□ adjusting the valve positions based on
· the first controlling parameters, and
. comparing the updated first processing information with the commonly applicable processing information, and
• adjusting the first controlling parameters for the first vacuum valve (10) based at least on the derived updated first processing information and the related valve positions.
